# EUROPÄISCHE PATENTSCHRIFT

(11) **EP 2 671 258 B1**
(45) Veröffentlichungstag und Bekanntmachung des Hinweises auf die Patenterteilung: **26.10.2016**
(21) Anmeldenummer: 12703290.2
(22) Anmeldetag: 03.02.2012
(51) Int. Cl.: H01L 31/0216, H01L 31/0725, H01L 31/0687, H01L 31/076

(54) **MEHRFACHSOLARZELLE SOWIE VERFAHREN ZUR HERSTELLUNG EINER SOLCHEN**
MULTI-SOLAR CELL, AND METHOD FOR PRODUCING SUCH A MULTI-SOLAR CELL
CELLULE SOLAIRE À JONCTIONS MULTIPLES ET PROCÉDÉ DE FABRICATION D'UNE TELLE CELLULE

(30) Priorität: 04.02.2011 DE 102011000521
(43) Veröffentlichungstag der Anmeldung: 11.12.2013
(73) Patentinhaber: AZUR SPACE Solar Power GmbH, 74072 Heilbronn (DE)
(72) Erfinder: STROBL, Gerhard, 70439 Stuttgart (DE)
(74) Vertreter: Koch Müller Patentanwaltsgesellschaft mbH
(86) Internationale Anmeldenummer: PCT/EP2012/051883
(87) Internationale Veröffentlichungsnummer: WO 2012/104421

(56) Entgegenhaltungen:
- EP-A2- 1 775 778
- WO-A1-2010/113708
- US-A- 5 389 159
- US-A1- 2010 059 101

## Beschreibung

Die Erfindung bezieht sich auf eine Mehrfachsolarzelle, umfassend ein Wafersubstrat sowie auf strahlenzugewandter Frontseite des Wafersubstrats abgeschiedene Solarzellenstruktur, die aus mehreren übereinander abgeschiedenen Solarzellen besteht, wobei das Substrat umlaufende Seitenflächen und die Solarzellenstruktur eine umlaufende Umfangsfläche aufweisen, die beabstandet zu den Seitenflächen verläuft, und wobei das Wafersubstrat auf seiner strahlenabgewandten Rückseite eine Rückseitenmetallisierung aufweist.

Auch nimmt die Erfindung Bezug auf ein Verfahren zur Herstellung einer Mehrfachsolarzelle, wobei auf strahlenzugewandter Frontseite eines Wafersubstrats Solarzellenstrukturen mit mehreren übereinander abgeschiedenen Unterzellen abgeschieden werden, wobei ein aktiver Solarzellenbereich als Solarzellenstruktur durch einen Ätz-, Laser- oder Sägeprozess mit nachfolgendem Überätzen unter Bildung einer Umfangsfläche definiert wird, das Wafersubstrat durch Sägen oder Lasern unter Bildung von umlaufenden Seitenflächen in Substratabschnitte zur Bildung der einzelnen Mehrfachsolarzellen getrennt wird, und wobei Rückseite des Wafersubstrats mit einer Rückseitenmetallisierung versehen wird.

Mehrfachsolarzellen (engl.: multi-junction solar cells) finden ihre Hauptanwendung in der Raumfahrt und terrestrischen lichtkonzentrierenden Photovoltaiksystemen (engl.: concentrator photovoltaics, CPV), die immer mehr an Bedeutung auf dem Photovoltaikmarkt gewinnen. Eine Voraussetzung für die Wirtschaftlichkeit und weitere Durchsetzung dieser Systeme ist eine lange ausfallfreie Lebensdauer. Dieser steht allerdings eine Kombination aus verschiedensten Umwelteinflüssen wie Feuchte, Temperaturschwankungen, UV-Licht gegenüber, die sich auf die Zuverlässigkeit einzelner Komponenten, Submodulen und Modulen negativ auswirken.

Für die Solarzelle, als Kernkomponente eines CPV-Moduls, ist u. a. eine dauernde Belastung mit kondensierter Feuchte kritisch, da diese zu elektro-chemischer Korrosion des Substratmaterials der Zelle und der Zellstruktur und weiterhin zu dem Ausfall der Solarzelle führen kann. Da die Frontseite der Solarzelle in der Regel durch Aufbringen eines Deckglases oder optischen Elements wie z. B. Linse oder Lichtverteiler geschützt ist, werden insbesondere die Kanten des Substrats und der Solarzellstruktur (Mesa) betroffen sein, an denen photoaktive Bereiche der Solarzelle ungeschützt sind.

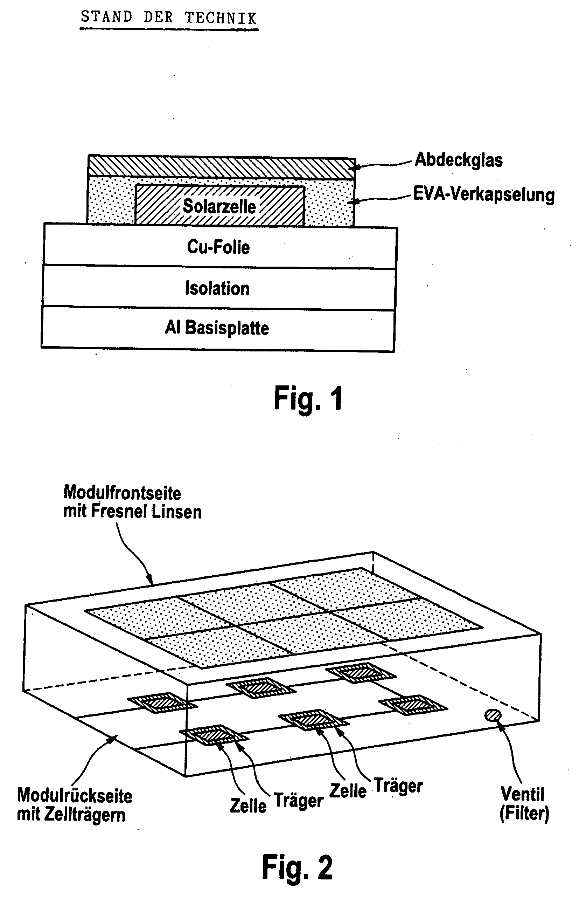

Fig. 1 zeigt einen Stand der Technik, der von einigen Firmen verfolgt wird, wobei eine Solarzelle auf einer leitenden Cu-Folie aufgebracht und mit einem Glas abgedeckt ist. Der Zwischenraum zwischen Abdeckglas und Cu-Folie ist mit einer EVA-Solarzellenverkapselung versehen, um die Solarzelle gegenüber der Umwelt abzukapseln.

Diese Versiegelungstechnik ist allerdings technisch aufwendig und durch das Abdeckglas mit hohem Gewicht verbunden.

Eine konventionelle CPV-Mehrfachsolarzelle besteht aus einem Substrat, wie Ge-Substrat oder GaAs-Substrat, mit darauf abgeschiedener Solarzellenstruktur. Dabei kann sich die unterste Zelle der Mehrfachsolarzelle während des Abscheideprozesses direkt in dem Substratmaterial bilden. Bei der Solarzellenfertigung werden die Größe des aktiven Solarzellenbereichs (Mesa) durch Ätz- oder Laserprozess oder Sägeprozess mit nachfolgendem Überätzen definiert und eine obere Metallisierung und Antireflexbeschichtung abgeschieden. Abschließend wird der Solarzellenwafer durch Sägen oder Lasern in einzelne Zellen getrennt.

Als Mesa wird im Allgemeinen eine Erhebung mit ebener Oberfläche und steiler Flanke bezeichnet.

Die gefertigten CPV-Solarzellen werden üblicherweise einzeln, z. B. in Fresnel-basierten Systemen, oder großflächig, z. B. in Dense-Array-Modulen, auf Träger geklebt oder gelötet. Im Falle von Fresnel-Optik-Modulen werden die Träger mit Solarzellen auf der Rückwand eines Modulinnenraums montiert und miteinander verschaltet. Um Druckdifferenzen zwischen dem Modulinnenraum und der Umgebung z. B. wegen Temperatur- und/oder Luftdruckvariationen zu vermeiden, werden die Module entweder offen oder mit einem Druckausgleichsfilter ausgeführt.

Der Filter kann ein wasserdampfundurchlässiges Membranmaterial enthalten, wie beispielsweise Gore-Tex ®, der das Eindringen von Feuchte in den Innenraum großenteils verhindern soll.

Alternativ kann die Rückwand des Moduls nach der kompletten Montage und dem Verschalten der Träger mit Zellen mit einer großflächigen durchsichtigen Polymerschicht versiegelt werden. Eine derartige Ausführungsform nach dem Stand der Technik ist in Fig. 2 dargestellt.

Als zusätzliche Maßnahme gegen Eindringen der Feuchte in den Modulinnenraum wird in manchen Systemen konstantes Spülen des Innenraums mit trockener Luft oder trockenem Stickstoff verwendet.

Der US-A-2009/0159119 ist eine Solarzelle zu entnehmen, deren Frontmetallisierung von einer Feuchtigkeitsbarriereschicht abgedeckt ist, die sich auch entlang der Seitenflächen der Solarzelle erstrecken kann. Als Material für die Schutzschicht kann Polyimid, Siliziumnitrid oder -oxid verwendet werden.

Gegenstand der US-A-2010/0018574 sind integrierte Dünnschichtsolarzellen.

Eine Metallisierung, die für Hochkonzentratorsolarzellen geeignet ist, wird in der US-A-5,075,763 beschrieben.

Die US-A-2010/0059101 bezieht sich auf eine Solarzellenanordnung mit zwei Gruppen von in Reihen verschalteten Solarzellen, die über eine Isolierschicht getrennt übereinander angeordnet sind.

Ein Dünnschicht-Silizium-Solarzellenmodul ist der WO-A-2010/113708 (= US-A-2012/0015472) zu entnehmen. Die Solarzellen sind auf einem aus Glas, Keramik oder Kunststoff bestehenden Substrat angeordnet und von einem Füllmaterial umgeben, das außenseitig von einer Schicht abgedeckt ist.

Mittels elektrostatischer Pulverbeschichtung wird nach der US-A-5 389 159 eine Solarzelle umfangsseitig eingekapselt.

Der vorliegenden Erfindung liegt die Aufgabe zugrunde, eine Mehrfachsolarzelle sowie ein Verfahren zur Herstellung einer Mehrfachsolarzelle der eingangs genannten Art so weiterzubilden, um Oxidation und Eindringen von Feuchte bei Mehrfachsolarzellen zu vermeiden.

Die Aufgabe wird erfindungsgemäß im Wesentlichen dadurch gelöst, dass die Umfangsfläche der Solarzellenstruktur unter in wesentlicher Auslassung strahlenzugewandter Oberseite der Solarzellenstruktur mit einer schützenden elektrisch isolierenden ersten Beschichtung beschichtet ist oder dass unter Freilassung der Solarzellenstruktur die Seitenflächen des Wafersubstrats von einer schützenden elektrisch isolierenden zweiten Beschichtung beschichtet sind oder dass sowohl die Seitenflächen des Wafersubstrats als auch die Umfangsfläche der Solarzellenstruktur unter in wesentlicher Auslassung strahlenzugewandter Oberseite der Solarzellenstruktur mit einer dritten Beschichtung beschichtet sind.

Vorzugsweise ist die Umfangsflächen-Beschichtung als Siliziumoxid- oder Siliziumnitrid-Beschichtung ausgebildet, wobei die Siliziumoxid- oder Siliziumnitrid-Beschichtung auf der Umfangsfläche abgeschieden ist, die auch als Mesakante oder Mesaflanke bezeichnet werden kann.

Gemäß einer weiteren bevorzugten Ausführungsform hat die Siliziumoxid- und/oder Siliziumnitrid-Beschichtung eine Dicke ds ≤ 1 µm, vorzugsweise eine Dicke ds im Bereich 100 nm ≤ ds ≤ 500 nm.

Eine weitere Ausführungsform zeichnet sich dadurch aus, dass die umlaufende Seitenfläche des Substrats und die Beschichtung der Umfangsfläche als Polyimid-Beschichtung ausgebildet ist, welche aus einem Polyimid besteht oder Polyimide enthält, wobei vorzugsweise die Polyimid-Beschichtung mittels Pinsel oder Dip-Prozess (Tauchprozess) aufgetragen ist.

Gemäß einer weiteren bevorzugten Ausführungsform weist die Polyimid-Beschichtung eine Dicke dp von weniger als 15 µm, vorzugsweise 5 µm ≤ dp ≤ 10 µm, auf.

Ferner zeichnet sich die Erfindung dadurch aus, dass Abstand a zwischen der Umfangsfläche der Solarzellenstruktur und den Seitenflächen des Substrats beträgt 10 µm ≤ a ≤ 100 µm.
Gegebenenfalls ist vorgesehen, dass sich die erste Beschichtung und/oder die dritte Beschichtung randseitig auf der strahlenzugewandten Oberseite der Solarzellenstruktur über eine Breite b mit 5 µm ≤ b ≤ 50 µm erstreckt.

Verfahrensmäßig wird die Aufgabe dadurch gelöst, dass unter in wesentlicher Auslassung strahlenzugewandter Oberseite der Solarzellenstruktur die Umfangsfläche der Solarzellenstruktur mit einer schützenden, elektrisch isolierenden ersten Beschichtung beschichtet wird oder dass die umlaufenden Seitenflächen des Substratabschnitts mit einer schützenden, elektrisch isolierenden zweiten Beschichtung beschichtet werden oder dass die Umfangsfläche der Solarzellenstruktur unter in wesentlicher Auslassung strahlenzugewandter Oberseite der Solarzellenstruktur und die umlaufenden Seitenflächen mit einer dritten Beschichtung beschichtet werden.

Gemäß einer bevorzugten Verfahrensweise wird die Beschichtung der Umfangsfläche der Solarzellenstruktur als Siliziumoxid-, Siliziumnitrid- und/oder Dielektrika-Beschichtung durch Abscheidung aufgebracht.

Dabei ist insbesondere vorgesehen, dass das Abscheiden der Schicht, also insbesondere der Siliziumoxid- oder Siliziumnitrid-Schicht vor Trennen des Substrats in die Teilabschnitte erfolgt, so dass sich die Beschichtung nicht nur entlang der Umfangsfläche der Solarzellenstrukturen, sondern auch entlang der solarzellenstrukturseitig verlaufenden Oberseite des Substrats erstreckt. Anschließend erfolgt das Durchtrennen in die Einzelabschnitte.

Des Weiteren zeichnet sich Erfindung dadurch aus, dass sowohl die Umfangsfläche der Solarzellenstruktur als auch die umlaufende Seitenfläche des Substratabschnitts, der auch vereinfacht als Substrat bezeichnet wird, mit einer dritten Beschichtung versehen wird, die insbesondere aus Polyimid besteht oder enthält. Das Aufbringen erfolgt durch Pinselauftrag, Dip-Prozess (Tauchverfahren) oder Siebdruckverfahren. In diesem Fall erstreckt sich die dritte Beschichtung auch entlang der solarzellenstrukturseitig verlaufenden Oberseite des Substrats, d. h. des Substratabschnitts.

Da sich die Umfangsfläche der Solarzellenstruktur abdeckende schützende elektrisch isolierende Beschichtung im Wesentlichen außerhalb der strahlenzugewandten Oberseite der Solarzellenstruktur erstreckt, könnte die Beschichtung auch lichtundurchlässig sein, ohne den Wirkungsgrad der Mehrfachsolarzelle negativ zu beeinflussen.

Anzumerken ist jedoch, dass herstellungsbedingt der Randbereich der Solarzellenstruktur, d. h. der strahlenzugewandten Oberseite, geringfügig von Beschichtungsmaterial abgedeckt ist. Die Breite des entsprechenden Randes liegt im Bereich zwischen 5 µm und 50 µm.

Des Weiteren ist vorgesehen, dass die Beschichtung der Umfangsfläche und der Seitenfläche mit demselben Beschichtungsmaterial erfolgt und vorzugsweise in einem Arbeitsschritt durchgeführt wird.

Vorzugsweise wird die Siliziumoxid-, Siliziumnitrid- und/oder Dielektrika-Beschichtung in einer Dicke ds mit ds ≤ 1 µm, vorzugsweise einer Dicke im Bereich 100 nm ≤ ds ≤ 500 nm, und dass die Polyimid-Beschichtung in einer Dicke dp mit dp ≤ 15 µm, vorzugsweise im Bereich 5 µm ≤ dp ≤ 10, µm aufgetragen.

Weitere Einzelheiten, Vorteile und Merkmale der Erfindung ergeben sich nicht nur aus den Ansprüchen, den diesen zu entnehmenden Merkmalen, - für sich und/oder in Kombination -, sondern auch aus der nachfolgenden Beschreibung von der Zeichnung zu entnehmenden bevorzugten Ausführungsbeispielen.

Es zeigen:
- Fig. 1: eine Schnittdarstellung einer eingekapselten Solarzelle nach dem Stand der Technik,
- Fig. 2: ein Solarzellenmodul nach dem Stand der Technik,
- Fig. 3a, b, c: eine perspektivische Darstellung einer Mehrfachsolarzelle sowie Ausschnitte dieser,
- Fig. 4a, b: eine perspektivische Darstellung einer Mehrfachsolarzelle sowie eine Schnittdarstellung der Mehrfachsolarzelle mit beschichteter Umfangsfläche der Solarzellenstruktur,
- Fig. 5a, b: eine perspektivische Darstellung einer Mehrfachsolarzelle sowie eine Schnittdarstellung der Mehrfachsolarzelle mit beschichteten umlaufenden Seitenflächen des Substrats,
- Fig.6a, b: eine perspektivische Darstellung einer Mehrfachsolarzelle sowie einer Schnittdarstellung der Mehrfachsolarzelle, bei der sowohl die Umfangsfläche der Solarzellenstruktur als auch die Substratseitenflächen mit unterschiedlichen Materialien beschichtet sind, und
- Fig. 7a, b: eine perspektivische Darstellung einer Mehrfachsolarzelle sowie eine Schnittdarstellung der Mehrfachsolarzelle, wobei die Umfangsfläche der Solarzellenstruktur und die Seitenflächen des Substrats mit demselben Material beschichtet ist.

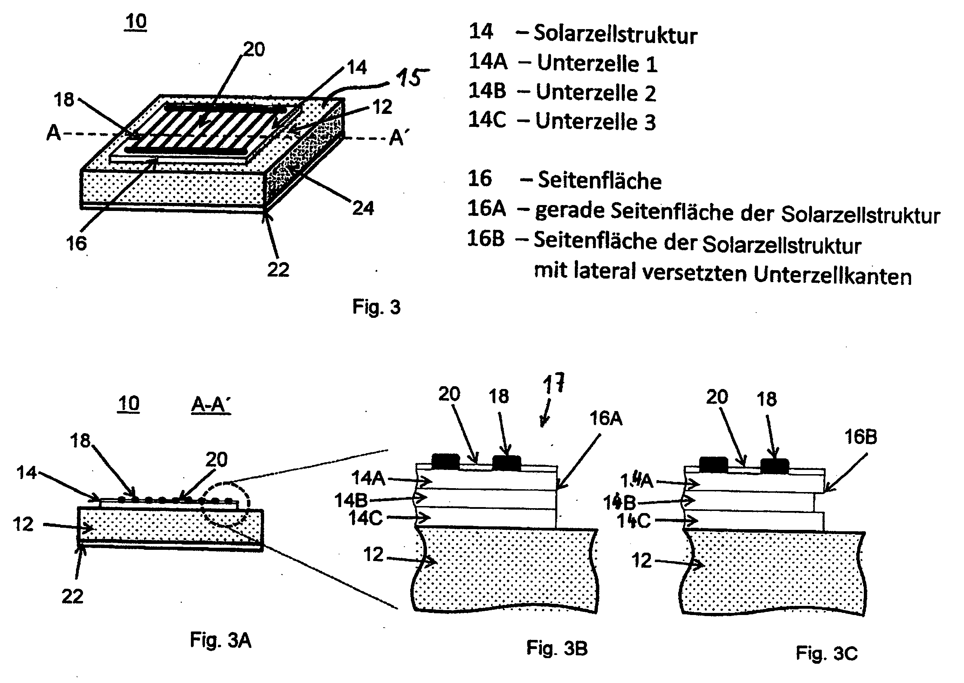

Fig. 3 zeigt eine Struktur einer konventionellen CPV-Mehrfachsolarzelle 10, umfassend ein Substrat 12, wie Ge- oder GaAs-Substrat, mit darauf abgeschiedener Solarzellenstruktur 14, wobei sich eine unterste Zelle der Mehrfachsolarzelle während eines Abscheideprozesses direkt in dem Substrat 12 bilden kann.

Bei der Fertigung von CPV-Mehrfachsolarzellen 10 werden üblicherweise auf einen ein Substrat bildenden Wafer epitaxial Halbleiterschichten aufgetragen. Bei dem Wafer- bzw. Substratmaterial handelt es sich üblicherweise um ein Ge- oder GeAs-Material. Die abgeschiedenen Schichten bilden Unterzellen, wobei entsprechend der Fig. 3 die Solarzellenstruktur die Unterzellen 14a, 14b, 14c umfassen kann. Nach dem Abscheiden von Halbleitermaterialien, Aufbringung eines Frontseitenkontakts 18, insbesondere in Form eines Metallgitters, sowie ggfs. einer Antireflexbeschichtung 20 sowie einer Rückseitenmetallisierung 22 auf der Rückseite des Substrats, werden durch Ätz-, Laser- oder Sägeprozesse mit nachfolgendem Überätzen aktive Solarzellenbereiche hergestellt, die eine Mesastruktur mit einer Umfangsfläche 16 aufweisen. Sodann wird das Substrat insbesondere durch Sägen in einzelne Substratabschnitte 12 getrennt, die jeweils eine umlaufende Seitenfläche 14 aufweisen.

Wie sich aus der zeichnerischen Darstellung der Fig. 3 ergibt, verläuft der aktive Bereich, also die Solarzellenstruktur 14 mit der Umfangsfläche 16 beabstandet zur umlaufenden Seitenfläche 24 des Substratabschnitts 12, der nachstehend vereinfacht als Substrat bezeichnet wird.

Wie sich aus den Fig. 3b und 3c ergibt, kann die Umfangsfläche 16 eben sein (Außenfläche 16) oder die Außenflächen der Unterzellen 14a, 14b, 14c verlaufen randseitig versetzt, also lateral versetzt (Umfangsfläche 16b). Dies ist in Fig. 3c rein prinzipiell dargestellt. Der Versatz entsteht dadurch, dass die unterschiedlichen Halbleitermaterialien der Unterzellen 14a, 14b, 14c unterschiedlich ätzresistent sind. Ungeachtet dessen verläuft jedoch die Umfangsfläche 16 bzw. 16a, 16b im Mittel gegenüber der umlaufenden Seitenfläche 24 des Substrats 12 in einem Abstand a mit 10 µm ≤ a ≤ 100 µm. Der Abstand a wird beispielhaft entlang der Linie A-A in Fig. 3 gemessen.

Um physikalische und chemische Reaktionen des Solarzellenmaterials und/oder des Substratmaterials mit der Umgebung zu vermeiden, welche zu elektrischen Kurzschlüssen und/oder Korrosion oder Zerstörung der Zellstrukturen führen können, ist erfindungsgemäß vorgesehen, dass die Umfangsfläche 16 der Solarzellenstruktur 14, also des aktiven Solarzellenbereichs einer jeden Mehrfachsolarzelle 10 oder die umlaufenden Seitenflächen 24 des Substrats 12 oder sowohl die Umfangsfläche 16 als auch die Seitenflächen 24 mit einer schützenden elektrisch isolierenden Beschichtung versehen sind, wie dies anhand der nachfolgenden Ausführungsbeispiele erläutert wird.

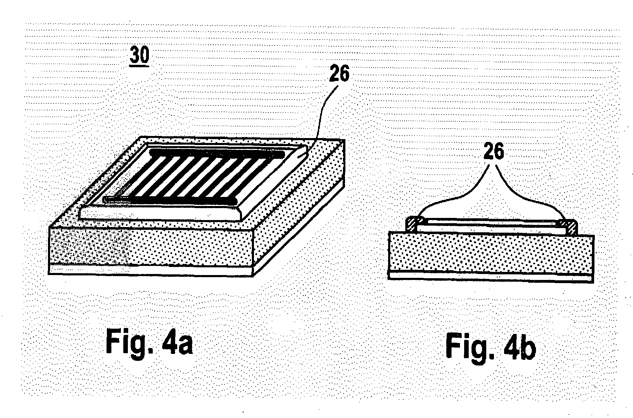

Die Fig. 4a und 4b zeigen eine Ausführungsform einer Mehrfachsolarzelle 30, bei der nur die Umfangsfläche 16, d. h. ein umlaufender Rand der Solarzellenstruktur 14 mit einer Beschichtung 26 in Form einer Siliziumoxid- oder Siliziumnitrid-Schicht beschichtet ist. Die Siliziumdioxid- oder Siliziumnitrid-Beschichtung wird vorzugsweise durch Abscheidung aufgebracht. Dieses Abscheiden erfolgt bevorzugterweise dann, bevor das Substrat, auf dem mehrere aktive Solarzellenbereiche, also Solarzellenstrukturen 14, abgeschieden werden, in die einzelnen Mehrfachsolarzellen durchtrennt wird. Somit erstreckt sich die Siliziumdioxid- bzw. Siliziumnitrid-Beschichtung nicht nur entlang der Umfangsfläche 16 einer jeden Solarzellenstruktur 14, sondern auch entlang strahlenzugewandter und somit solarzellenseitiger Oberseite 15 des Substrats 12. Die strahlenzugewandte Oberfläche 17 der Solarzellenstruktur 14 und damit Mehrfachsolarzelle bleibt - ggfs. mit Ausnahme eines Randbereichs - unbedeckt.

Das Abscheiden der Siliziumoxid- oder Siliziumnitrid-Schichten erfolgt vorzugsweise aus der Gasphase mittels CVD-Verfahren.

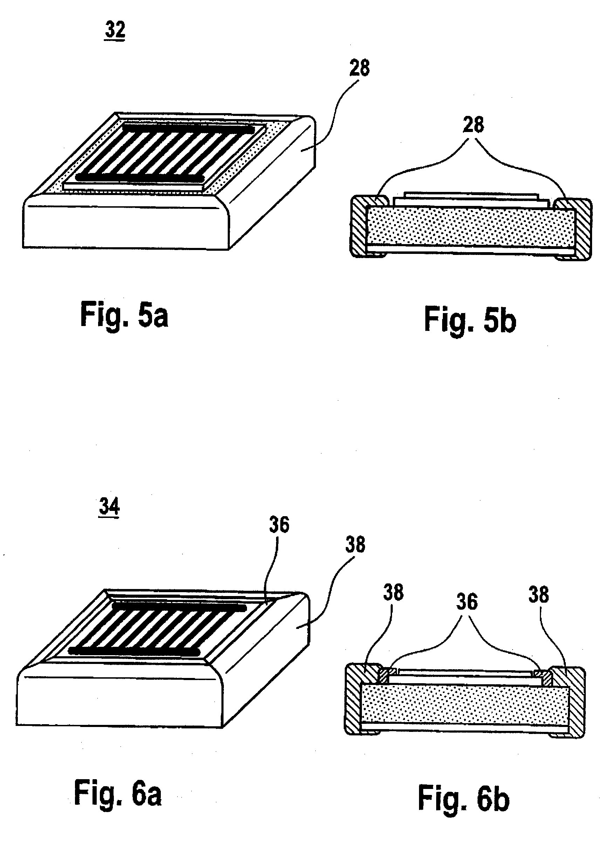

Alternativ ist in den Fig. 5a, 5b eine Ausführungsform einer Mehrfachsolarzelle 32 dargestellt, bei der nur die umlaufenden Seitenflächen 24 des Substrats 12 mit einer Beschichtung 28 in Form z. B. einer Polyimid-Schicht, welche aus einem Polyimid besteht oder Polyimide enthält, versehen ist. Die Polyimid-Schicht wird mittels Pinsel aufgetragen, oder mittels Siebdruckverfahren in einem Dip-Prozess (Tauchprozess) aufgebracht, und zwar vorzugsweise getrennt für jede Mehrfachsolarzelle.

Fig. 6a und 6b zeigen eine weitere Ausführungsform einer Mehrfachsolarzelle 34, die sich dadurch auszeichnet, dass die Mehrfachsolarzelle 34 sowohl eine Umfangsflächen-Beschichtung 36 der Solarzellenstruktur 14 als auch eine Seitenflächen-Beschichtung 38 des Substrats 12 aufweist. In dem dargestellten Ausführungsbeispiel sind zwei verschiedene Beschichtungsmaterialien eingesetzt, nämlich Siliziumdioxid bzw. Siliziumnitrid für die Umfangsflächen-Beschichtung 36 und Polyimid bzw. Polyimide für die Seitenflächen-Beschichtung 38. Erstreckt sich in der zeichnerischen Darstellung die Polyimid-Beschichtung 36 auch entlang der solarzellenstrukturseiten Oberseite des Substrats 12, so ist - wie zuvor erläutert - der diesbezügliche Bereich vorzugsweise mit der Siliziumdioxid- bzw. Siliziumnitrid-Schicht abgedeckt.

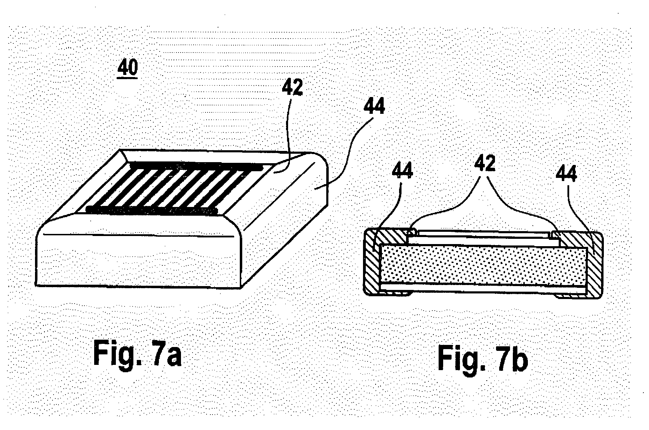

Fig. 7a, 7b zeigen eine weitere Ausführung einer Mehrfachsolarzelle 40, wobei eine Umfangsflächen-Beschichtung 42 der Solarzellenstruktur 14 bzw. des aktiven Solarzellenbereichs sowie eine umlaufende Seitenflächen-Beschichtung 44 des Substrats 14 mit demselben Beschichtungsmaterial durchgeführt wurde. Als Beschichtungsmaterial wurde ein Polyimid bzw. Polyimide eingesetzt.

Die Dicke ds der Siliziumoxid- oder Siliziumnitrid-Beschichtung 26, 36 liegt im Bereich ds ≤ 1 µm, vorzugsweise 100 nm ≤ ds ≤ 500 nm. Die Dicke dp der Polyimid-Beschichtung 28, 38, 42, 44 liegt im Bereich dp ≤ 15 µm, vorzugsweise 5 µm ≤ dp ≤ 10 µm.

Weitere bevorzugte Abmessungen sind:
Dicke des Substrats 12: 120 µm bis 170 µm, vorzugsweise 150 µm;
Dicke der Solarzellenstruktur 14 oberhalb der Oberseite des Substrats 12: 13 µm bis 17 µm, vorzugsweise 15 µm;
Länge des Substrats 12: 0,9 cm bis 1,1 cm, wobei die Grundfläche des Substrats quadratisch ist.

## Patentansprüche

1. Mehrfachsolarzelle (10, 30, 32, 34, 40), umfassend ein Wafersubstrat (12) sowie auf strahlenzugewandter Frontseite des Wafersubstrats (12) abgeschiedene Solarzellenstruktur (14), die aus mehreren übereinander abgeschiedenen Solarzellen (14a, 14b, 14c) besteht, wobei das Substrat umlaufende Seitenflächen (24) und die Solarzellenstruktur eine umlaufende Umfangsfläche (16, 16a, 16b) aufweisen, die beabstandet zu den Seitenflächen verläuft, und wobei das Wafersubstrat auf seiner strahlenabgewandten Rückseite eine Rückseitenmetallisierung (22) aufweist,
**dadurch gekennzeichnet,**
**dass** die'Umfangsfläche (16, 16a, 16b) der Solarzellenstruktur (14) unter in wesentlicher Auslassung strahlenzugewandter Oberseite (17) der Solarzellenstruktur mit einer schützenden elektrisch isolierenden ersten Beschichtung (26, 36) beschichtet ist oder
**dass** unter Freilassung der Solarzellenstruktur die Seitenflächen (24) des Wafersubstrats (12) von einer schützenden elektrisch isolierenden zweiten Beschichtung (28, 38) beschichtet sind oder
**dass** sowohl die Seitenflächen des Wafersubstrats als auch die Umfangsfläche der Solarzellenstruktur unter in wesentlicher Auslassung strahlenzugewandter Oberseite der Solarzellenstruktur mit einer dritten Beschichtung (42, 44) beschichtet sind.

2. Mehrfachsolarzelle nach Anspruch 1,
**dadurch gekennzeichnet,**
**dass** die erste Beschichtung (26, 36) eine Siliziumoxid- oder Siliziumnitrid-Beschichtung ist, die sich gegebenenfalls entlang solarzellenstrukturseitiger Oberseite des Substrats (12) erstreckt.

3. Mehrfachsolarzelle nach Anspruch 1,
**dadurch gekennzeichnet,**
**dass** die zweite und/oder dritte Beschichtung (28, 38, 42, 44) als Polyimid-Beschichtung ausgebildet ist, die aus Polyimid besteht oder Polyimide enthält.

4. Mehrfachsolarzelle nach Anspruch 2,
**dadurch gekennzeichnet,**
**dass** die Siliziumoxid- oder Siliziumnitrid-Beschichtung (26, 36) eine Dicke ds mit ds ≤ 1 µm, vorzugsweise eine Dicke ds im Bereich 100 mm ≤ ds ≤ 500 nm, aufweist.

5. Mehrfachsolarzelle nach Anspruch 3,
**dadurch gekennzeichnet,**
**dass** Polyimid-Beschichtung (28, 36) eine Dicke dp mit dp ≤ 15 µm, vorzugsweise eine Dicke dp im Bereich 5 µm ≤ dp ≤ 10 µm, aufweist.

6. Mehrfachsolarzelle nach Anspruch 1,
**dadurch gekennzeichnet,**
**dass** Abstand a zwischen der Umfangsfläche (16, 16a, 16b) der Solarzellenstruktur (14) und den Seitenflächen (24) des Wafersubstrats (12) beträgt 10 µm ≤ a ≤ 100 µm.

7. Mehrfachsolarzelle nach Anspruch 1,
**dadurch gekennzeichnet,**
**dass** sich die erste Beschichtung (26, 36) und/oder die dritte Beschichtung (42) randseitig auf der strahlenzugewandten Oberseite der Solarzellenstruktur (14) über eine Breite b mit 5 µm ≤ b ≤ 50 µm erstreckt.

8. Mehrfachsolarzelle nach Anspruch 1,
**dadurch gekennzeichnet,**
**dass** das Wafersubstrat ein Ge- oder GaAs-Substrat ist.

9. Verfahren zur Herstellung einer Mehrfachsolarzelle, wobei auf strahlenzugewandter Frontseite eines Wafersubstrats Solarzellenstrukturen mit mehreren übereinander abgeschiedenen Unterzellen (14, 14a, 14b, 14c) abgeschieden werden, wobei ein aktiver Solarzellenbereich als Solarzellenstruktur durch einen Ätz-, Laser- oder Sägeprozess mit nachfolgendem Überätzen unter Bildung einer Umfangsfläche (16) definiert wird, das Wafersubstrat durch Sägen oder Lasern unter Bildung von umlaufenden Seitenflächen in Substratabschnitte (12) zur Bildung der einzelnen Mehrfachsolarzellen (10, 32, 34, 40) getrennt wird, und wobei Rückseite des Wafersubstrats mit einer Rückseitenmetallisierung (22) versehen wird,
**dadurch gekennzeichnet,**
**dass** unter in wesentlicher Auslassung strahlenzugewandter Oberseite (17) der Solarzellenstruktur (14) die Umfangsfläche (16) der Solarzellenstruktur (14) mit einer schützenden, elektrisch isolierenden ersten Beschichtung (26, 36) beschichtet wird oder
**dass** die umlaufenden Seitenflächen (14) des Substratabschnitts (12) mit einer schützenden, elektrisch isolierenden zweiten Beschichtung (28, 38) beschichtet werden oder
**dass** die Umfangsfläche der Solarzellenstruktur unter in wesentlicher Auslassung strahlenzugewandter Oberseite der Solarzellenstruktur und die umlaufenden Seitenflächen mit einer dritten Beschichtung (42, 44) beschichtet werden.

10. Verfahren nach Anspruch 9,
**dadurch gekennzeichnet,**
**dass** als erste Beschichtung (26, 36) eine Siliziumoxid-, Siliziumnitrid- und/oder Dielektrika-Beschichtung durch Abscheidung aufgebracht wird.

11. Verfahren nach Anspruch 9 oder 10,
**dadurch gekennzeichnet,**
**dass** die erste Beschichtung vor Trennen des Substrats in die Substratabschnitte (12) durch Abscheiden aufgebracht wird und sich sowohl entlang der Umfangsfläche (16) der Solarzellenstruktur (14) als auch solarzellenstrukturseitiger Oberseite des Substrats erstreckt.

12. Verfahren nach Anspruch 9,
**dadurch gekennzeichnet,**
**dass** als zweite Beschichtung (28, 38, 42, 44) eine Polyimid-Beschichtung aufgebracht wird.

13. Verfahren nach Anspruch 12,
**dadurch gekennzeichnet,**
**dass** die Polyimid-Beschichtung durch Pinselauftrag oder Siebdruckverfahren aufgebracht wird.

14. Verfahren nach Anspruch 9,
**dadurch gekennzeichnet,**
**dass** die erste und/oder dritte Beschichtung (26, 36, 42) strahlenzugewandte Oberseite (17) der Sölarzellenstruktur (14) unbedeckt lässt oder sich ausschließlich bis zu einem Randbereich auf der strahlenzugewandten Oberseite der Solarzellenstruktur erstreckt, der eine Breite b mit 5 µm ≤ b ≤ 50 µm aufweist.

## Claims

1. Multiple solar cell (10, 30, 32, 34, 40), comprising a wafer substrate (12) and a solar cell structure (14), which is deposited on a front side of the wafer substrate (12) facing radiation and which consists of a plurality of solar cells (14a, 14b, 14c) deposited one above the other, wherein the substrate has encircling side surfaces (24) and the solar cell has an encircling circumferential surface (16, 16a, 16b) extending at a spacing from the side surfaces, and wherein the wafer substrate has a rear side metallisation (22) on its rear side remote from radiation,
**characterised in that**
the circumferential surface (16, 16a, 16b) of the solar cell structure (14) is coated with a protective electrically insulating first coating (26, 36) substantially with omission of the upper side (17) of the solar cell structure facing radiation or
the side surfaces (24) of the wafer substrate (12) are coated by a protective electrically insulating second coating (28, 38) while leaving free the solar cell structure or
both the side surfaces of the wafer substrate and the circumferential surface of the solar cell structure are coated with a third coating (42, 44) substantially with the omission of the upper side of the solar cell structure facing radiation.

2. Multiple solar cell according to claim 1, **characterised in that** the first coating (26, 36) is a silicon oxide or silicon nitride coating which optionally extends along the upper side of the substrate (12) at the solar cell structure side.

3. Multiple solar cell according to claim 1, **characterised in that** the second and/or third coating (28, 38, 42, 44) is or are constructed as a polyimide coating consisting of polyimide or containing polyimides.

4. Multiple solar cell according to claim 2, **characterised in that** the silicon oxide or silicon nitride coating (26, 36) has a thickness ds, in which ds ≤ 1 micron, preferably a thickness ds in the range of 100 nanometres ≤ ds ≤ 500 nanometres.

5. Multiple solar cell according to claim 3, **characterised in that** the polyimide coating (28, 38) has a thickness dp, in which dp ≤ 15 microns, preferably a thickness dp in the range 5 microns ≤ dp ≤ 10 microns.

6. Multiple solar cell according to claim 1, **characterised in that** the spacing a between the circumferential surface (16, 16a, 16b) of the solar cell structure (14) and the side surfaces (24) of the wafer substrate (12) is 10 microns ≤ a ≤ 100 microns.

7. Multiple solar cell according to claim 1, **characterised in that** the first coating (26, 36) and/or the third coating (42) extends or extend at the edge side on the upper side of the solar cell structure (14) facing the radiation over a width b in which 5 microns ≤ b ≤ 50 microns.

8. Multiple solar cell according to claim 1, **characterised in that** the wafer substrate is a Ge or GaAs substrate.

9. Method of producing a multiple solar cell, wherein solar cell structures with a plurality of sub-cells (14, 14a, 14b, 14c) deposited one above the other are deposited on a front side of a wafer substrate facing radiation, wherein an active solar cell region is defined as a solar cell structure by an etching, laser-cutting or sawing process with subsequent over-etching to form a circumferential surface (16), the wafer substrate is separated by sawing or laser-cutting to form encircling side surfaces in substrate sections (12) for formation of the individual multiple solar cells (10, 32, 34, 40), and wherein the rear side of the wafer substrate is provided with a rear-side metallisation (22),
**characterised in that**
the circumferential surface (16) of the solar cell structure (14) is coated with a protective electrically insulating first coating (26, 36) substantially with omission of the upper side (17) of the solar cell structure (14) facing radiation or
the encircling side surfaces (24) of the substrate section (12) are coated with a protective electrically insulating second coating (28, 38) or
the circumferential surface of the solar cell structure - substantially with the omission of the upper side of the solar cell structure facing radiation - and the encircling side surfaces are coated with a third coating (42).

10. Method according to claim 9, **characterised in that** a silicon oxide, silicon nitride and/or dielectric coating is applied by deposition as the first coating (26, 36).

11. Method according to claim 9 or 10, **characterised in that** the first coating is applied by deposition prior to separation of the substrate into the substrate sections (12) and extends not along the circumferential surface (16) of the solar cell structure (14), but also along the upper side of the substrate at the solar cell structure side.

12. Method according to claim 9, **characterised in that** a polyimide coating is applied as second coating (28, 38, 42, 44).

13. Method according to claim 12, **characterised in that** the polyimide coating is applied by brush coating or by a screen-printing process.

14. Method according to claim 9, **characterised in that** the first and/or third coating (26, 36, 42) leaves uncovered the upper side (17) of the solar cell structure (14) facing radiation or extends exclusively up to an edge region on the upper side of the solar cell structure facing radiation, which has a width b in which 5 micron ≤ b ≤ 50 microns.

## Revendications

1. Cellule solaire à jonctions multiples (10, 30, 32, 34, 40) comprenant un substrat de galette (12) ainsi qu'une structure de cellules solaires (14) déposée sur une face avant tournée vers le rayonnement du substrat de galette (12), qui se compose de plusieurs cellules solaires séparées et déposées l'une au-dessus de l'autre (14a, 14b, 14c), dans laquelle le substrat présente des faces latérales périphériques (24) et la structure de cellules solaires présente une surface périphérique (16, 16a, 16b) qui est espacée des faces latérales, et dans laquelle le substrat de galette présente une métallisation arrière (22) sur sa face arrière détournée du rayonnement,
**caractérisée en ce que**
la surface latérale (16, 16a, 16b) de la structure de cellules solaires (14) est, essentiellement à l'exception de la face supérieure tournée vers le rayonnement (17) de la structure de cellules solaires, revêtue avec un premier revêtement protecteur électriquement isolant (26, 36) ou
les faces latérales (24) du substrat de galette (12) sont revêtues avec un deuxième revêtement protecteur électriquement isolant (28, 38), avec la structure de cellules solaires laissée libre,
aussi bien les faces latérales du substrat de galette que la surface latérale de la structure de cellules solaires sont revêtues avec un troisième revêtement (42, 44) essentiellement à l'exception de la face supérieure tournée vers le rayonnement de la structure de cellules solaires.

2. Cellule solaire à jonctions multiples selon la revendication 1, **caractérisée en ce que** le premier revêtement (26, 36) est un revêtement d'oxyde de silicium ou de nitrure de silicium qui s'étend éventuellement le long de la face supérieure côté structure de cellules solaires du substrat (12).

3. Cellule solaire à jonctions multiples selon la revendication 1, **caractérisée en ce que** le deuxième et/ou le troisième revêtement (28, 38, 42, 44) est un revêtement de polyimide qui se compose de polyimide ou qui contient des polyimides.

4. Cellule solaire à jonctions multiples selon la revendication 2, **caractérisée en ce que** le revêtement d'oxyde de silicium ou de nitrure de silicium (26, 36) présente une épaisseur ds avec ds ≤ 1 µm, de préférence une épaisseur ds dans la plage 100 nm ≤ ds ≤ 500 nm.

5. Cellule solaire à jonctions multiples selon la revendication 3, **caractérisée en ce que** le revêtement de polyimide (28, 38) présente une épaisseur dp avec dp ≤ 15 µm, de préférence une épaisseur dp dans la plage 5 µm ≤ dp ≤ 10 µm.

6. Cellule solaire à jonctions multiples selon la revendication 1, **caractérisée en ce que** la distance a entre la surface latérale (16, 16a, 16b) de la structure de cellules solaires (14) et les faces latérales (24) du substrat de galette (12) vaut 10 µm ≤ a ≤ 100 µm.

7. Cellule solaire à jonctions multiples selon la revendication 1, **caractérisée en ce que** le premier revêtement (26, 36) et/ou le troisième revêtement (42) s'étend en bordure sur la face supérieure tournée vers le rayonnement de la structure de cellules solaires (14) sur une largeur b avec 5 µm ≤ b ≤ 50 µm.

8. Cellule solaire à jonctions multiples selon la revendication 1, **caractérisée en ce que** le substrat de galette est un substrat de Ge ou de GaAs.

9. Procédé de fabrication d'une cellule solaire à jonctions multiples, dans lequel on dépose sur la face avant tournée vers le rayonnement d'un substrat de galette des structures de cellules solaires avec plusieurs sous-cellules déposées l'une au-dessus de l'autre (14, 14a, 14b, 14c), dans lequel on définit une zone de cellule solaire active comme structure de cellules solaires par un processus de gravure, de coupe au laser ou de sciage avec regravure ultérieure avec formation d'une surface latérale (16), on découpe le substrat de galette par sciage ou coupe au laser avec formation de faces latérales périphériques dans des sections du substrat (12) pour la formation des cellules solaires à jonctions multiples individuelles (10, 32, 34, 40) et dans lequel on dote la face arrière du substrat de galette d'une métallisation arrière (22),
**caractérisé en ce que**
essentiellement à l'exception de la face supérieure tournée vers le rayonnement (17) de la structure de cellules solaires (14), on revêt la surface périphérique (16) de la structure de cellules solaires (14) avec un premier revêtement protecteur électriquement isolant (26, 36), ou
on revêt les faces latérales périphériques (24) de la section de substrat (12) avec un deuxième revêtement protecteur électriquement isolant (28, 38), ou
on revêt la surface périphérique de la structure de cellules solaires essentiellement à l'exception de la face supérieure tournée vers le rayonnement de la structure de cellules solaires et les faces latérales périphériques avec un troisième revêtement (42,44).

10. Procédé selon la revendication 9, **caractérisé en ce que** l'on applique par précipitation comme premier revêtement (26, 36) un revêtement d'oxyde de silicium, de nitrure de silicium et/ou de diélectrique.

11. Procédé selon la revendication 9 ou 10, **caractérisé en ce que** l'on applique par précipitation le premier revêtement avant le découpage du substrat en sections de substrat (12) et il s'étend aussi bien le long de la surface latérale (16) de la structure de cellules solaires (14) que de la face supérieure du substrat côté structure de cellules solaires.

12. Procédé selon la revendication 9, **caractérisé en ce que** l'on applique comme deuxième revêtement (28, 38, 42, 44) un revêtement de polyimide.

13. Procédé selon la revendication 12, **caractérisé en ce que** l'on applique le revêtement de polyimide par application au pinceau ou par sérigraphie.

14. Procédé selon la revendication 9, **caractérisé en ce que** le premier et/ou le troisième revêtement (26, 36, 42) laisse la face supérieure tournée vers le rayonnement (17) de la structure de cellules solaires (14) non recouverte ou s'étend exclusivement jusqu'à une zone de bordure sur la face supérieure tournée vers le rayonnement de la structure de cellules solaires qui présente une largeur b avec 5 µm ≤ b ≤ 50 µm.
